# EUROPÄISCHE PATENTSCHRIFT

(11) **EP 2 926 372 B1**
(45) Veröffentlichungstag und Bekanntmachung des Hinweises auf die Patenterteilung: **15.07.2020**
(21) Anmeldenummer: 13789225.3
(22) Anmeldetag: 29.10.2013
(51) Int. Cl.: H01L 25/16, H01L 23/34, H01L 33/64, H01L 23/367, H01L 23/373, H01L 23/00

(54) **VERFAHREN ZU HERSTELLUNG EINER HALBLEITERVORRICHTUNG**
METHOD OF MANUFACTURING A SEMICONDUCTOR DEVICE
PROCÉDÉ DE FABRICATION D'UN DISPOSITIF SEMI-CONDUCTEUR

(30) Priorität: 27.11.2012 DE 102012111458
(43) Veröffentlichungstag der Anmeldung: 07.10.2015
(73) Patentinhaber: TDK Electronics AG, 81671 München (DE)
(72) Erfinder: FEICHTINGER, Thomas, A-8010 Graz (AT); RINNER, Franz, A-8530 Deutschlandsberg (AT)
(74) Vertreter: Epping - Hermann - Fischer
(86) Internationale Anmeldenummer: PCT/EP2013/072613
(87) Internationale Veröffentlichungsnummer: WO 2014/082809

(56) Entgegenhaltungen:
- WO-A1-2009/141439
- DE-U1-202011 108 919
- JP-A- 2008 172 113
- US-A1- 2006 138 443
- US-A1- 2010 078 668
- US-A1- 2012 032 182

## Beschreibung

Es wird ein Verfahren zur Herstellung einer Halbleitervorrichtung mit einem Halbleiterbauelement angegeben.

Leistungshalbleiter weisen ab einer kritischen Temperatur des Halbleiterübergangs, die auch als T_{J} ("junction temperature") bezeichnet werden kann, eine signifikante Verringerung ("derating") der Lebensdauer und der Leistungsfähigkeit ("performance") auf. Zu typischen Leistungshalbleitern gehören beispielsweise Licht emittierende Dioden (LEDs), insbesondere so genannte High-Power-LEDs, integrierte Schaltungen (IC) wie beispielsweise High-Power-Grafikchips, Leistungsverstärker ("power amplifier") sowie Leistungstransistoren wie beispielsweise Power-MOSFETs und IGBTs. Ein Derating beginnt beispielsweise bei High-Power-LEDs typischerweise bei einer Temperatur T_{J} von etwa 105 °C, bei IGBTs typischerweise bei einer Temperatur T_{J} von etwa 175 °C. Insbesondere bei LEDs besteht nicht nur die Gefahr, dass die Lebensdauer des Leistungshalbleiters an sich verringert wird, sondern auch dass beispielsweise verwendete Leuchtstoff-Silikonschichten degradieren, wodurch sich das Lichtspektrum einer LED in unerwünschter Weise ändern könnte. In herkömmlichen Systemlösungen ist die Temperatur des Leistungshalbleiters im Betrieb vielfach nicht genau genug bekannt, sodass die Leistung auf einen Sicherheitswert begrenzt werden muss, der üblicherweise bei 85 bis 90 % der maximal nutzbaren Leistung liegt. Eine weitere Steigerung der Leistung ohne die Gefahr eines Deratings erfordert einen thermisch optimierten Träger sowie eine Temperaturüberwachung.

Ein effizientes Temperaturmanagement spielt beispielsweise im Falle von LEDs bei der Dimensionierung der Lichtleistung, insbesondere der maximal erreichbaren Lichtleistung (in Lumen/Watt), eine immer wichtigere Rolle. Aufgrund der begrenzten Modellierungsgenauigkeiten des Trägersystems muss die Temperatur von LEDs auf 85 bis 90 °C heruntergeregelt werden, sodass die LEDs nicht mit maximaler Leistung bei der im Hinblick auf das Derating maximal möglichen Temperatur von typischerweise 105 °C betrieben werden können. Hieraus resultieren Performance-Verluste von etwa 5 % pro 10 °C niedrigerer Temperatur.

Bei Lösungen gemäß dem Stand der Technik werden beispielsweise Leistungshalbleiter und ein Temperatursensor nebeneinander auf einem Keramikträger oder Siliziumträger aufgebracht, wobei ein oder mehrere Leistungshalbleiter auf einer ebenen Fläche eines Trägers aufgesetzt werden, auf der auch ein Temperatursensorelement angeordnet ist. Die Leistungshalbleiter können dabei jeweils auch individuelle Träger ("Level-1-Träger") aufweisen, mit denen sie auf den gemeinsamen Träger ("Level-2-Träger") aufgebracht werden. Über den gemeinsamen Träger wiederum erfolgt eine Montage auf einer Wärmesenke. Hierdurch ergeben sich an einer Vielzahl von Grenzflächen wie etwa Lötverbindungen thermische Widerstände und Übergangsleitwerte, die meist relativ ungenau beschreibbar sind. Die Temperatur, die der Temperatursensor neben dem einen oder den mehreren Leistungshalbleitern misst, wird durch die thermischen Widerstände und die Übergangsleitwerte zwischen den einzelnen Komponenten sowie durch die Wärmeleitung in den einzelnen Komponenten, wie etwa im gemeinsamen Träger und in der Wärmesenke, bestimmt und stellt damit zu einem gewissen Grad nur eine indirekte Messung dar. Durch die zusätzliche Anordnung eines Temperatursensors auf einem gemeinsamen Träger mit einem oder mehreren Leistungshalbleitern wird zusätzlich auch noch ein erhöhter Platzbedarf und damit eine größere Baugröße in Kauf genommen.

Um einen möglichst guten Wärmeübergang von einem Leistungshalbleiter auf eine Wärmesenke zu erreichen, wird beispielsweise versucht, die Anzahl dazwischen angeordneter Komponenten und Materialien, beispielsweise in Form von Trägerkörpern, so weit wie möglich zu reduzieren oder einen Leistungshalbleiter sogar direkt auf eine Wärmesenke zu montieren.

Zumindest eine Aufgabe von bestimmten Ausführungsformen ist es, ein Verfahren zur Herstellung einer Halbleitervorrichtung anzugeben, die eine Messung einer Temperatur eines im Betrieb Wärme erzeugenden Halbleiterbauelements ermöglicht.

Diese Aufgabe wird durch einen Gegenstand gemäß dem unabhängigen Patentanspruch gelöst. Vorteilhafte Ausführungsformen und Weiterbildungen des Gegenstands sind in den abhängigen Ansprüchen gekennzeichnet und gehen weiterhin aus der nachfolgenden Beschreibung und den Zeichnungen hervor.

Gemäß zumindest einer Ausführungsform weist eine Halbleitervorrichtung als Produkt des erfindungsgemäßen Verfahrens ein Halbleiterbauelement auf. Das Halbleiterbauelement kann beispielsweise ein Leistungshalbleiterbauelement sein. Das Leistungshalbleiterbauelement kann etwa ein Halbleiterbauelement sein, das ohne ausreichende Kühlung im vorgesehenen Betrieb eine Temperatur erreichen kann, durch die das Halbleiterbauelement geschädigt werden könnte. Beispielsweise kann das Halbleiterbauelement ausgewählt sein aus einer Licht emittierenden Diode, einer integrierten Schaltung wie etwa einem Grafikchip, einem Verstärkerchip und einem Transistor. Insbesondere kann das Halbleiterbauelement beispielsweise eine High-Power-LED, ein High-Power-Grafikchip, ein Leistungsverstärker, ein Power-MOSFET oder ein IGBT sein.

Weiterhin weist die Halbleitervorrichtung einen Trägerkörper auf, auf dem das Halbleiterbauelement montiert ist. Der Trägerkörper ist insbesondere ein vom Halbleiterbauelement separat hergestellter Trägerkörper, auf den das fertiggestellte Halbleiterbauelement aufgebracht beziehungsweise montiert wird. Der Trägerkörper weist eine in den Trägerkörper integrierte Thermistorsensorstruktur auf, die dazu vorgesehen und eingerichtet ist, über eine Widerstandsänderung eine Temperaturmessung zu ermöglichen. Die Thermistorsensorstruktur kann besonders bevorzugt durch ein NTC-Thermistor-Material gebildet werden und beispielsweise als ein- oder mehrschichtiges Thermistor-Bauelement ausgebildet sein, das über geeignete Kontaktierungen eine Widerstandsmessung erlaubt. Insbesondere kann die Thermistorsensorstruktur ein geeignetes NTC-Keramikmaterial aufweisen. Alternativ hierzu kann die Thermistorsensorstruktur beispielsweise auch ein PTC-Material, beispielsweise eine PTC-Keramik, aufweisen. Materialien und prinzipielle Aufbauten von keramischen NTC- und PTC-Thermistoren sind dem Fachmann bekannt und werden daher hier nicht weiter ausgeführt.

Weiterhin weist der Trägerkörper einen Keramikkörper auf, der in direkter Verbindung mit der Thermistorsensorstruktur, die in den Trägerkörper integriert ist, steht. Der Keramikkörper kann dabei insbesondere im Hinblick auf eine geeignete Trägereigenschaft und Stabilität sowie eine möglichst hohe Wärmeleitfähigkeit ausgebildet sein. Beispielsweise kann der Keramikkörper Aluminiumoxid und/oder Aluminiumnitrid aufweisen. Der Keramikkörper kann beispielsweise als Trägermaterial für die in den Trägerkörper integrierte Thermistorsensorstruktur ausgebildet sein. Mit anderen Worten kann die Thermistorsensorstruktur auf dem Keramikkörper aufgebracht sein. Der Keramikkörper und die Thermistorsensorstruktur werden erfindungsgemäß in einem gemeinsamen Prozess monolithisch gefertigt.

Gemäß zumindest einer Ausführungsform weist der Keramikkörper einen größeren elektrischen Widerstand als die Thermistorsensorstruktur auf. Insbesondere kann der Keramikkörper beispielsweise einen elektrischen Widerstand von mehr als 50000 Ω·cm aufweisen. Die integrierte Thermistorsensorstruktur kann einen elektrischen Widerstand von weniger als 5000 Ω·cm, bevorzugt von weniger als 2000 Ω·cm und besonders bevorzugt von weniger als 1000 Ω·cm aufweisen. Soweit nicht anders gekennzeichnet, ist hier und im Folgenden mit "elektrischer Widerstand" der spezifische elektrische Widerstand bezeichnet. Beispielsweise kann der Keramikkörper im Vergleich zur Thermistorsensorstruktur auch elektrisch isolierend sein.

Weiterhin weist die Halbleitervorrichtung eine Wärmesenke auf, auf der der Trägerkörper montiert ist. Die Wärmesenke kann insbesondere als metallische Wärmesenke ausgebildet sein. Eine metallische Wärmesenke bezeichnet hierbei eine Wärmesenke, die im Wesentlichen aus einem Metallkörper besteht, auf den beispielsweise zur elektrischen Isolierung bereichsweise oder großflächig elektrisch isolierende Schichten und/oder zum elektrischen Anschluss der Halbleitervorrichtung und/oder des Halbleiterbauelements elektrische Kontaktbereiche, Leiterbahnen und/oder Anschlüsse aufgebracht sein können.

Insbesondere ist die hier beschriebene Halbleitervorrichtung derart ausgebildet, dass im Betrieb einen leistungsbezogenen Temperaturunterschied zwischen dem Halbleiterbauelement und der Thermistorsensorstruktur kleiner als 3 K/W ist. Ein derart geringer Temperaturunterschied zwischen dem Halbleiterbauelement und der Thermistorsensorstruktur kann insbesondere durch eines oder mehrere der folgenden Ausgestaltungen für den Keramikkörper erreicht werden.

Bei der hier beschriebenen Halbleitervorrichtung ist die Thermistorsensorstruktur insbesondere in einem Wärmeableitungspfad zwischen dem Halbleiterbauelement und der Wärmesenke angeordnet, also entlang eines Temperaturgradienten, der sich im Betrieb in der Halbleitervorrichtung ausbildet. Der Wärmeableitungspfad kann dabei insbesondere auch der Anordnungsrichtung des Trägerkörpers und des Halbleiterbauelements auf der Wärmesenke entsprechen. Mit anderen Worten wird durch die hier beschriebene spezielle Anordnung der Thermistorsensorstruktur die im Betrieb im Halbleiterbauelement erzeugte Wärme, die in Richtung der Wärmesenke durch den Trägerkörper abgeleitet wird, zwangsläufig durch die Thermistorsensorstruktur geleitet. Hierdurch kann eine direktere Temperaturmessung der Temperatur des Halbleiterbauelements erreicht werden als dies bei üblichen Leistungshalbleitersystemen der Fall ist, bei denen ein Temperatursensor auf einem gemeinsamen Träger neben einem Leistungshalbleiter angeordnet ist. Weiterhin kann durch die Integration der Thermistorsensorstruktur in den Trägerkörper eine geringe Baugröße beziehungsweise -höhe erreicht werden. Speziell bei mobilen Anwendungen wie beispielsweise einem integrierten LED-Kamerablitz in einem Smartphone oder einer Digitalkamera kann die hier beschriebene Halbleitervorrichtung im Vergleich zu einer üblichen Bauform mit einer LED und einem diskreten Temperatursensor weniger Platzbedarf durch eine geringere Bauhöhe und/oder eine geringere Bauteilfläche aufweisen.

Gemäß einer weiteren Ausführungsform ist die Thermistorsensorstruktur von der Wärmesenke aus gesehen über dem Keramikkörper, also zwischen dem Keramikkörper und dem Halbleiterbauelement, angeordnet. Hierdurch kann erreicht werden, dass die Thermistorsensorstruktur in großer Nähe zum Wärme erzeugenden Halbleiterbauelement angeordnet ist, wodurch möglichst unmittelbar die Temperatur des Halbleiterbauelements messbar sein kann.

Weiterhin kann es auch möglich sein, dass die Thermistorsensorstruktur von der Wärmesenke aus gesehen unterhalb des Keramikkörpers, also auf der vom Halbleiterbauelement abgewandten Seite des Keramikkörpers, angeordnet ist. Hierdurch kann beispielsweise erreicht werden, dass das Halbleiterbauelement von der Wärmesenke aus gesehen auf einer Oberseite durch eine Kontaktstruktur des Trägerkörpers elektrisch kontaktiert werden kann, während die Thermistorsensorstruktur auf einer Unterseite des Trägerkörpers getrennt vom Halbleiterbauelement elektrisch kontaktiert werden kann.

Weiterhin ist es auch möglich, dass der Trägerkörper beispielsweise mehrere Thermistorsensorstrukturen, beispielsweise von der Wärmesenke aus gesehen auf der Oberseite sowie auf der Unterseite des Keramikkörpers, aufweist.

Um eine möglichst gute Wärmeableitung zu ermöglichen, kann der Trägerkörper beispielsweise zusätzlich auch eine Metallschicht oder Metallfolie aufweisen, die beispielsweise auf einer der Thermistorsensorstruktur abgewandten Seite des Keramikkörpers angeordnet sein kann.

Darüber hinaus ist es auch möglich, dass der Trägerkörper thermische Vias aufweist, die durch den Keramikkörper hindurchragen und die beispielsweise durch Metall gefüllte Öffnungen im Keramikkörper gebildet werden. Die thermischen Vias können insbesondere mit der Thermistorsensorstruktur in thermischem Kontakt stehen. Durch die thermischen Vias kann durch den Keramikkörper hindurch eine effektive Wärmeableitung erreicht werden.

Gemäß einer weiteren Ausführungsform ist der Trägerkörper direkt auf der Wärmesenke montiert. Hierzu kann die Wärmesenke beispielsweise ein Kontaktpad aufweisen, auf dem der Trägerkörper aufgeklebt oder aufgelötet ist. Weiterhin kann der Trägerkörper auch direkt über ein geeignetes Verbindungsmaterial, beispielsweise ein Lot oder einen Klebstoff, auf der Wärmesenke montiert sein. Durch einen möglichst unmittelbaren thermischen Kontakt zwischen dem Trägerkörper und der Wärmesenke kann eine möglichst hohe Wärmeableitung aus dem Halbleiterbauelement erreicht werden.

Weiterhin kann es auch möglich sein, dass auf der Wärmesenke eine Mehrzahl von Trägerkörpern angeordnet ist, die jeweils ein darauf montiertes Halbleiterbauelement aufweisen. Die Wärmesenke kann hierzu eine entsprechende Mehrzahl von Kontaktpads aufweisen. Zur elektrischen Isolation der Trägerkörper zueinander kann die Wärmesenke auch zwischen einem Metallkörper und den Trägerkörpern eine Isolatorschicht aufweisen. Mit "isolierend", "Isolation" und "Isolator" wird, soweit nicht explizit anders angegeben ist, eine elektrisch isolierende Eigenschaft bezeichnet.

Gemäß einer weiteren Ausführungsform weist der Trägerkörper auf der der Wärmesenke abgewandten Seite, auf der auch das Halbleiterbauelement aufgebracht ist, eine Kontaktstruktur auf, mittels derer das Halbleiterbauelement auf dem Trägerkörper montiert ist. Die Kontaktstruktur kann gleichzeitig zur elektrischen Kontaktierung des Halbleiterbauelements dienen. Weiterhin kann der Trägerkörper eine Metallstruktur zur Umverdrahtung und zur elektrischen Kontaktierung des Halbleiterbauelements von außen, also beispielsweise an eine externe Strom- und/oder Spannungsquelle, aufweisen, die mit der Kontaktstruktur zur Montage des Halbleiterbauelements elektrisch leitend verbunden ist. Über die Metallstruktur kann beispielsweise ein elektrischer Anschluss des Halbleiterbauelements mittels Drahtverbindungen, beispielsweise mittels Bonddrähten, erfolgen. Weiterhin kann auch die Wärmesenke Metallstrukturen in Form von Leiterbahnen und/oder elektrischen Anschlussstellen aufweisen, die mit der Metallstruktur des Trägerkörpers beispielsweise über Drahtkontaktierungen verbunden sind.

Gemäß einer weiteren Ausführungsform weist der Trägerkörper zwischen der Thermistorsensorstruktur und dem Halbleiterbauelement eine Isolatorschicht auf. Diese kann beispielsweise als Trägerschicht für eine Kontaktstruktur und/oder eine Metallstruktur zur Umverdrahtung ausgebildet sein und insbesondere auch das Halbleiterbauelement von der Thermistorsensorstruktur elektrisch isolieren. Für den Fall, dass das Halbleiterbauelement als Licht emittierende Diode ausgebildet ist, kann die Isolatorschicht besonders bevorzugt auch reflektierend, beispielsweise weiß, ausgebildet sein. Beispielsweise kann die Isolatorschicht durch ein keramisches Material, etwa Aluminiumoxid, Titanoxid oder Siliziumdioxid, oder ein Kunststoffmaterial gebildet sein.

Gemäß einer weiteren Ausführungsform ist auf der Wärmesenke zusätzlich ein diskretes Schutzbauelement angeordnet. "Diskret" bedeutet hierbei, dass das Schutzbauelement nicht in den Trägerkörper integriert ist, sondern getrennt vom Trägerkörper und dem darauf angeordneten Halbleiterbauelement auf der Wärmesenke montiert und dort elektrisch angeschlossen ist. Das diskrete Schutzbauelement kann beispielsweise ein ESD-Schutzbauelement sein.

Weitere Vorteile, vorteilhafte Ausführungsformen und Weiterbildungen ergeben sich aus den im Folgenden in Verbindung mit den Figuren beschriebenen Ausführungsbeispielen, d.h. Halbleitervorrichtungen, die mittels eines Ausführungsbeispiels des erfindungsgemäßen Verfahrens hergestellt wurden.

Es zeigen:
- Figur 1: eine schematische Darstellung einer Halbleitervorrichtung gemäß einem Ausführungsbeispiel,
- Figur 2: eine schematische Darstellung einer Halbleitervorrichtung gemäß einem weiteren Ausführungsbeispiel,
- Figur 3: eine schematische Darstellung einer Halbleitervorrichtung gemäß einem weiteren Ausführungsbeispiel,
- Figur 4: eine schematische Darstellung einer Halbleitervorrichtung gemäß einem weiteren Ausführungsbeispiel, und
- Figur 5: eine schematische Darstellung einer Halbleitervorrichtung gemäß einem weiteren Ausführungsbeispiel.

In den Ausführungsbeispielen und Figuren können gleiche, gleichartige oder gleich wirkende Elemente jeweils mit denselben Bezugszeichen versehen sein. Die dargestellten Elemente und deren Größenverhältnisse untereinander sind nicht als maßstabsgerecht anzusehen, vielmehr können einzelne Elemente, wie zum Beispiel Schichten, Bauteile, Bauelemente und Bereiche, zur besseren Darstellbarkeit und/oder zum besseren Verständnis übertrieben groß dargestellt sein.

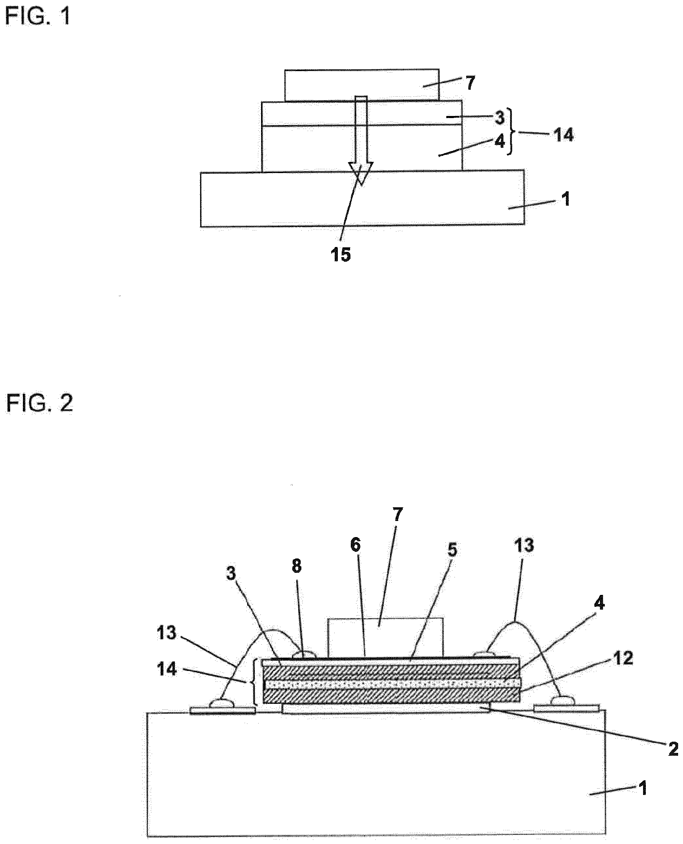

In Figur 1 ist ein Ausführungsbeispiel für eine Halbleitervorrichtung gezeigt, die übereinander auf einer Wärmesenke 1 einen Trägerkörper 14 und auf diesem ein Halbleiterbauelement 7 aufweist. Das Halbleiterbauelement 7 kann insbesondere ein Leistungshalbleiterbauelement, beispielsweise ausgewählt aus einer Licht emittierenden Diode, einem Grafikchip, einem Verstärkerchip und einem Transistor sein. Beispielsweise kann das Halbleiterbauelement 7 eine so genannte High-Power-LED oder ein Power-Transistor wie beispielsweise ein Power-MOSFET oder ein IGBT sein. Der Trägerkörper 14 weist einen Keramikkörper 4 und eine in den Trägerkörper 14 integrierte Thermistorsensorstruktur 3 als Temperatursensor auf. Die Thermistorsensorstruktur 3 steht in direkter Verbindung mit dem Keramikkörper 4 und ist von der Wärmesenke 1 aus gesehen auf dem Keramikkörper angeordnet. Der Keramikkörper 4 und die Thermistorsensorstruktur 3 werden gemeinsam hergestellt und bilden ein monolithisches Keramikteil.

Im Betrieb der Halbleitervorrichtung erzeugt das Halbleiterbauelement 7 Wärme, die einem Temperaturgradienten zwischen dem Halbleiterbauelement 7 und der Wärmesenke 1 erzeugt und die durch den Trägerkörper 14 zur Wärmesenke 1 abgeführt wird. Die Thermistorsensorstruktur 3 des Trägerkörpers 14 ist somit in einem dem Temperaturgradienten entsprechenden Wärmeableitungspfad, der durch den Pfeil 15 angedeutet ist, zwischen dem Halbleiterbauelement 7 und der Wärmesenke 1 angeordnet. Hierdurch weist die Halbleitervorrichtung zum einen eine geringe Baugröße durch kompakte Abmessungen auf, da zur Temperaturmessung kein separates, neben dem Trägerkörper und/oder dem Halbleiterbauelement 7 anzuordnendes Temperatursensorelement nötig ist. Weiterhin kann durch die in den Trägerkörper 14 integrierte Thermistorsensorstruktur 3 ein Temperatursensor in unmittelbarer Nähe zum Halbleiterbauelement 7 angeordnet werden, wodurch eine direkte Messung der Temperatur des Halbleiterbauelements möglich ist.

Dadurch und auch durch die im Weiteren in Verbindung mit den folgenden Figuren beschriebenen Merkmale ist es bei der hier beschriebenen Halbleitervorrichtung möglich, dass die Halbleitervorrichtung im Betrieb einen Temperaturunterschied zwischen dem Halbleiterbauelement 7 und der Thermistorsensorstruktur 3 von weniger als 3 K/W aufweist.

Der Keramikkörper 4 des Trägerkörpers 14 weist einen größeren elektrischen Widerstand als die Thermistorsensorstruktur 3 auf. Insbesondere kann der Keramikkörper beispielsweise einen elektrischen Widerstand von mehr als 50000 Ω·cm aufweisen, während die in den Trägerkörper 14 integrierte Thermistorsensorstruktur 3 einen elektrischen Widerstand von weniger als 5000 Ω·cm, bevorzugt von weniger als 2000 Ω·cm und besonders bevorzugt von weniger als 1000 Ω·cm aufweist.

Die Thermistorsensorstruktur 3 ist insbesondere als NTC-Thermistor ausgebildet, also als so genannter Heißleiter, der bei Erhöhung der Temperatur mit einer Verringerung des elektrischen Widerstands reagiert. Die Thermistorsensorstruktur ist insbesondere auf einem keramischen NTC-Thermistor-Material basierend ausgebildet und kann ein- oder mehrschichtig mit geeigneten elektrischen Kontakten ausgeführt sein, um den elektrischen Widerstand der Thermistorsensorstruktur von außen messen zu können.

Der Keramikkörper 4 dient zum einen der mechanischen Stabilität des Trägerkörpers 14, zum anderen auch einer möglichst hohen Wärmeableitung vom Halbleiterbauelement 7 zur Wärmesenke 1. Hierzu weist der Keramikkörper 4 bevorzugt ein Keramikmaterial auf, das eine hohe Wärmeleitfähigkeit aufweist, beispielsweise Aluminiumoxid oder Aluminiumnitrid.

Die Wärmesenke 1 ist bevorzugt hier und in den folgenden Ausführungsbeispielen als metallische Wärmesenke ausgebildet. Das bedeutet, dass die Wärmesenke 1 im Hinblick auf ihre thermischen Eigenschaften im Wesentlichen aus einem Metallkörper besteht, der beispielsweise auch eine geeignete Oberflächenstruktur wie beispielsweise Rippen oder Lamellen aufweisen kann. Weiterhin kann die Wärmesenke 1, sofern erforderlich, eine oder mehrere Isolatorschichten und/oder elektrische und/oder mechanische Kontaktbereiche aufweisen.

Elektrische Kontaktstrukturen sowie elektrische und/oder mechanische Verbindungsschichten sind im Ausführungsbeispiel der Figur 1 der Übersichtlichkeit halber nicht gezeigt und werden in Verbindung mit den folgenden Figuren näher beschrieben.

Auf Basis des in Figur 1 gezeigten Ausführungsbeispiels für die Halbleitervorrichtung wurden Simulationen durchgeführt, bei denen ausgehend von bekannten Bauformen von LED-Modulen Temperaturverteilungen und Temperaturunterschiede im Bereich des Halbleiterbauelements 7, des Trägerkörpers 14 und der Wärmesenke 1 simuliert wurden. Dadurch wurde gefunden, dass die integrierte Thermistorsensorstruktur 3 im Betrieb einen Temperaturunterschied von beispielsweise weniger als 2 K/W zum Halbleiterbauelement 7 aufweist, während ein Referenz-Temperatursensor an der im Stand der Technik üblichen Position neben dem Halbleiterbauelement 7 einen Temperaturunterschied von mehr als 10 K/W aufwies. Somit ist offensichtlich, dass durch die hier beschriebene integrierte Anordnung der Thermistorsensorstruktur in den Trägerkörper 14 entlang des Wärmeableitungspfads vom Halbleiterbauelement 7 zur Wärmesenke 1 eine deutlich genauere Messung der Temperatur des Halbleiterbauelements möglich ist.

Die in folgenden Figuren gezeigten Ausführungsbeispiele stellen Modifikationen und Weiterentwicklungen des in Verbindung mit Figur 1 beschriebenen Ausführungsbeispiels dar. Die folgende Beschreibung beschränkt sich daher im Wesentlichen auf die Unterschiede und Modifikationen zum Ausführungsbeispiel der Figur 1.

In Figur 2 ist ein Ausführungsbeispiel für eine Halbleitervorrichtung gezeigt, bei der, wie schon im Ausführungsbeispiel der Figur 1, von der Wärmesenke 1 aus gesehen die in den Trägerkörper 14 integrierte Thermistorsensorstruktur 3 auf dem Keramikkörper 4 angeordnet ist. Somit befindet sich die Thermistorsensorstruktur 3 zwischen dem Halbleiterbauelement 7 und dem Keramikkörper 4 des Trägerkörpers 14. Um eine möglichst hohe Wärmeableitung zur Wärmesenke 1 hin zu ermöglichen, weist der Trägerkörper 14 weiterhin auf der der Thermistorsensorstruktur 3 abgewandten Seite des Keramikkörpers 4 eine Metallfolie 12, im gezeigten Ausführungsbeispiel insbesondere eine Kupferfolie, auf. Der Trägerkörper 14 ist auf einem Kontaktpad 2 der Wärmesenke 1 montiert, beispielsweise durch Auflöten oder durch Kleben.

Der Keramikkörper 4 ist zur elektrischen Isolation der Thermistorsensorstruktur 3 zur Metallfolie 12 insbesondere aus einem Material mit einem hohen elektrischen Widerstand gebildet und weist bevorzugt eine Durchbruchspannung von mehr als 3 kV auf.

Zur elektrischen Kontaktierung des Halbleiterbauelements 7 weist der Trägerkörper 14 eine Kontaktstruktur 6 auf, über die das Halbleiterbauelement 7 auf den Trägerkörper 14 montiert ist. Beispielsweise kann das Halbleiterbauelement 7 auf der Kontaktstruktur 6 aufgelötet sein. Darüber hinaus kann es auch möglich sein, dass ein elektrischer Kontakt zu einer Kontaktstruktur des Trägerkörpers über eine Drahtverbindung, beispielsweise einen Bonddraht, hergestellt wird. Zum elektrischen Anschluss der Kontaktstruktur 6 weist der Trägerkörper 14 weiterhin eine Metallstruktur 8 zur Umverdrahtung auf, die dadurch insbesondere auch zum elektrischen Anschluss des Halbleiterbauelements 7 von außen dient. Im gezeigten Ausführungsbeispiel weist die Halbleitervorrichtung hierzu Drahtverbindungen 13 in Form von Bonddrähten auf, die einen elektrischen Kontakt zu geeigneten Kontaktpads auf der Wärmesenke 1 herstellen. Diese können beispielsweise durch eine Isolatorschicht auf der Wärmesenke 1 gegeneinander elektrisch isoliert sein und weitere Anschlussmöglichkeiten für einen Anschluss an eine externe Strom- und/oder Spannungsquelle aufweisen. Die Metallstruktur 8 kann weiterhin auch zur elektrischen Kontaktierung der Thermistorsensorstruktur 3 ausgebildet sein.

Um einen elektrischen Kontakt zwischen dem Halbleiterbauelement 7 und der Thermistorsensorstruktur 3 zu vermeiden, weist der Trägerkörper 14 weiterhin zwischen dem Halbleiterbauelement 7 und der Thermistorsensorstruktur 3 eine Isolatorschicht 5 auf, die beispielsweise ein isolierendes Keramikmaterial wie etwa Titanoxid, Aluminiumoxid oder Siliziumoxid aufweisen oder daraus sein kann. Ist das Halbleiterbauelement 7 beispielsweise als Licht emittierende Diode ausgebildet, kann die Isolatorschicht 5 bevorzugt reflektierend und diesbezüglich beispielsweise weiß ausgebildet sein. Alternativ zu einem Keramikmaterial kann beispielsweise auch ein geeignetes Kunststoffmaterial verwendet werden.

Über dem Halbleiterbauelement 7 und insbesondere beispielsweise auch über dem Trägerkörper 14 kann eine Umhüllung angeordnet sein, die zum Schutz des Halbleiterbauelements 7 und des Trägerkörpers 14 dienen kann. Beispielsweise kann die Umhüllung durch einen Kunststoffverguss gebildet sein. Für den Fall, dass das Halbleiterbauelement 7 als Licht emittierende Diode ausgebildet ist, kann die Umhüllung auch als optischer Verguss, beispielsweise mit oder aus Silikon, ausgebildet sein und beispielsweise in Form einer Linse über dem Halbleiterbauelement 7 angeordnet sein. Weiterhin kann die Umhüllung in diesem Fall beispielsweise auch einen Leuchtstoff aufweisen.

Durch die Ausbildung des Trägerkörpers 14 als sogenannten Chip-Carrier für das Halbleiterbauelement 7 mit einem integrierten Temperatursensor in Form der Thermistorsensorstruktur 3 kann somit zum einen eine wie in Verbindung mit Figur 1 beschriebene genaue Temperaturmessung sowie eine kompakte Bauform erreicht werden. Durch die direkte Montage des Trägerkörpers 14 auf der Wärmesenke 1 kann zudem eine effiziente Wärmeableitung aus dem Halbleiterbauelement 7 erreicht werden.

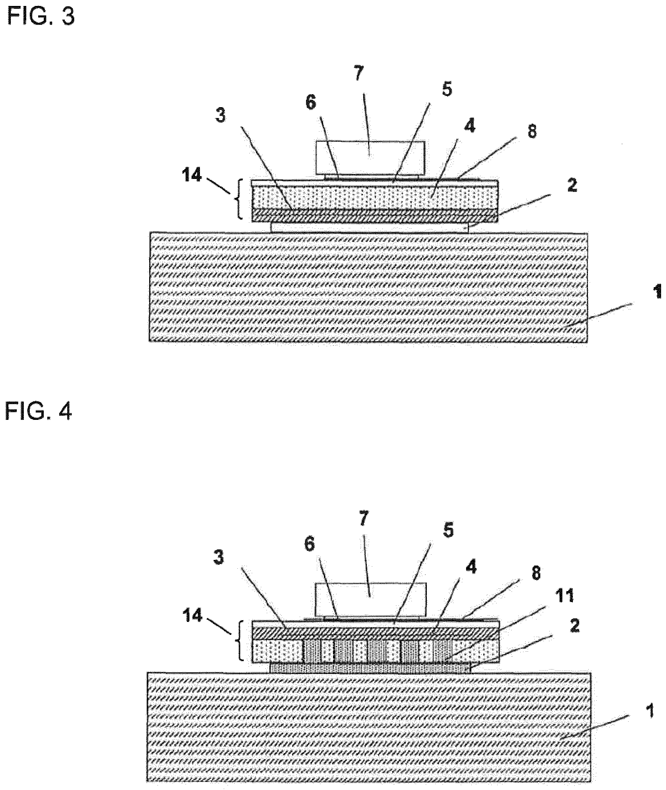

In Figur 3 ist ein weiteres Ausführungsbeispiel für eine Halbleitervorrichtung gezeigt, bei der im Vergleich zum vorherigen Ausführungsbeispiel die integrierte Thermistorsensorstruktur 3 auf der dem Halbleiterbauelement 7 abgewandten Seite des Keramikkörpers 4 angeordnet ist. Hierdurch kann es beispielsweise möglich sein, die elektrische Kontaktierung des Halbleiterbauelements 7 und der Thermistorsensorstruktur 3 auf zwei unterschiedlichen Seiten des Trägerkörpers 14 auszubilden. Beispielsweise kann die Thermistorsensorstruktur 3 auch direkt über das Kontaktpad 2 elektrisch kontaktierbar sein. Der Keramikkörper 4 kann im Hinblick auf seine Dicke und sein Material insbesondere derart ausgewählt sein, dass der Trägerkörper 14 die erforderliche mechanische Stabilität aufweist und gleichzeitig eine hohe Wärmeleitung vom Halbleiterbauelement 7 zur integrierten Thermistorsensorstruktur 3 erlaubt, um einen Temperaturunterschied zwischen dem Halbleiterbauelement 7 und der Thermistorsensorstruktur 3 von weniger als 3 K/W im Betrieb zu ermöglichen. Hierzu sind insbesondere die vorgenannten Materialien für den Keramikkörper 4 geeignet.

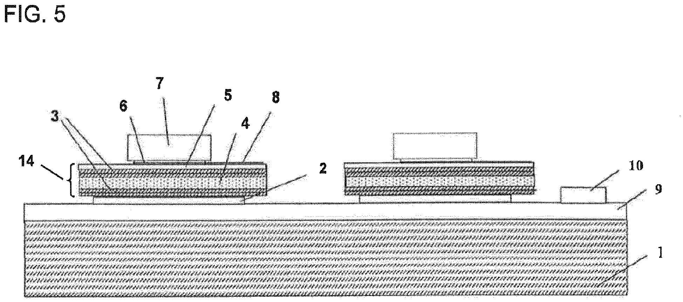

Weiterhin kann auch, wie auch in Verbindung mit Figur 5 gezeigt ist, eine Kombination der Ausführungsbeispiele der Figuren 2 und 3 möglich sein, bei denen zwei Thermistorsensorstrukturen 3 in den Trägerkörper 14 integriert sind, die auf unterschiedlichen Seiten des Keramikkörpers 4 angeordnet sind und in direktem Kontakt mit dem Keramikkörper 4 stehen.

In Figur 4 ist ein weiteres Ausführungsbeispiel für eine Halbleitervorrichtung gezeigt, bei der zur Erhöhung der Wärmeleitung durch den Keramikkörper 4 in diesem thermische Vias 11 vorgesehen sind, die durch den Keramikkörper 4 hindurch ragen und die im thermischen Kontakt mit der integrierten Thermistorsensorstruktur 3 stehen. Die thermischen Vias 11 können beispielsweise durch Metall gefüllte Öffnungen gebildet werden. Je nach Ausbildung des Trägerkörpers 14 und der Thermistorsensorstruktur 3 können zwischen den thermischen Vias und der Thermistorsensorstruktur 3 Isolatorschichten angeordnet sein, um die von der Wärmesenke 1 aus gesehene Unterseite des Trägerkörpers 14 elektrisch von der Thermistorsensorstruktur 3 zu isolieren.

In Figur 5 ist ein weiteres Ausführungsbeispiel gezeigt, das im Hinblick auf die Trägerkörper 14 eine Kombination der Ausführungsbeispiele der Figuren 2 und 3 zeigt. Weiterhin weist die Halbleitervorrichtung der Figur 5 im Vergleich zu den vorherigen Ausführungsbeispielen eine Mehrzahl von Trägerkörpern 14 mit jeweils einem darauf montierten Halbleiterbauelement 7 auf. Die Trägerkörper 14 können auch anders als in Figur 5 gezeigt gemäß den vorherigen Ausführungsbeispielen ausgebildet sein.

Die Halbleiterbauelemente 7 können gleich oder unterschiedlich ausgebildet sein. Beispielsweise kann es sich bei der Mehrzahl der Halbleiterbauelemente 7 um eine Mehrzahl von LEDs, insbesondere High-Power-LEDs, handeln, sodass die Halbleitervorrichtung gemäß dem Ausführungsbeispiel der Figur 5 als Blitzlicht oder Scheinwerfermodul ausgebildet sein kann. Weiterhin können die Halbleiterbauelemente 7 auf den verschiedenen Trägerkörpern 14 auch unterschiedlich ausgeführt sein und somit unterschiedliche Funktionalitäten für die Halbleitervorrichtung bereitstellen.

Um eine elektrische Isolation der Halbleiterbauelemente 7 und der Trägerkörper 14 jeweils zueinander zu erreichen, weist die Wärmesenke 1 eine Isolatorschicht 9 auf, auf der die Trägerkörper 14 über Kontaktpads 2 montiert sind.

Weiterhin weist die Halbleitervorrichtung ein diskretes Schutzbauelement 10 auf der Wärmesenke 1 auf, also ein elektrisches Bauelement, das nicht in die Trägerkörper 14 integriert ist, sondern getrennt von den Trägerkörpern auf der Wärmesenke 1 montiert ist. Das Schutzbauelement 10 kann beispielsweise als ESD-Schutzbauelement ausgebildet sein und einen Schutz der Halbleitervorrichtung vor elektrostatischen Entladungen bilden.

Gemäß weiteren Ausführungsbeispielen können die in Verbindung mit den Figuren gezeigten Ausführungsbeispiele auch miteinander kombiniert sein, auch wenn derartige Merkmalskombinationen nicht explizit beschrieben sind. Weiterhin können die in den Figuren gezeigten Ausführungsbeispiele weitere oder alternative Merkmale gemäß der Beschreibung im allgemeinen Teil aufweisen.

Die Erfindung ist nicht durch die Beschreibung anhand der Ausführungsbeispiele auf diese beschränkt.

### Bezugszeichenliste

- 1: Wärmesenke
- 2: Kontaktpad
- 3: Thermistorsensorstruktur
- 4: Keramikkörper
- 5: Isolatorschicht
- 6: Kontaktstruktur
- 7: Halbleiterbauelement
- 8: Metallstruktur
- 9: Isolatorschicht
- 10: diskretes Schutzbauelement
- 11: thermisches Via
- 12: Metallfolie
- 13: Drahtverbindung
- 14: Trägerkörper
- 15: Wärmeableitungspfad

## Patentansprüche

1. Verfahren zur Herstellung einer Halbleitervorrichtung mit den Schritten:
- Bereitstellen eines Halbleiterbauelements (7),
- Bereitstellen eines Trägerkörpers (14), auf dem das Halbleiterbauelement (7) montiert wird und der einen Keramikkörper (4) und eine in den Trägerkörper (14) integrierte Thermistorsensorstruktur (3) in direkter Verbindung mit dem Keramikkörper (4) aufweist, wobei der Keramikkörper (4) und die Thermistorsensorstruktur (3) in einem gemeinsamen Prozess hergestellt werden und ein monolithisches Keramikteil bilden, und
- Bereitstellen einer Wärmesenke (1), auf der der Trägerkörper (14) montiert wird.

2. Verfahren nach Anspruch 1, wobei die Thermistorsensorstruktur (3) in einem Wärmeableitungspfad (15) zwischen dem Halbleiterbauelement (7) und der Wärmesenke (1) angeordnet ist.

3. Verfahren nach Anspruch 2, wobei die Thermistorsensorstruktur (3) entlang des Wärmeableitungspfads (15) auf einer dem Halbleiterbauelement (7) zugewandten oder abgewandten Seite des Trägerkörpers (14) angeordnet ist.

4. Verfahren nach Anspruch 3, wobei die Thermistorsensorstruktur (3) entlang des Wärmeableitungspfads (15) auf einer dem Halbleiterbauelement (7) zugewandten Seite des Trägerkörpers (14) angeordnet ist und der Trägerkörper (14) weiterhin eine Metallfolie (12) auf einer dem Halbleiterbauelement (7) abgewandten Seite aufweist.

5. Verfahren nach Anspruch 4, wobei die Metallfolie (12) eine Kupferfolie ist.

6. Verfahren nach Anspruch 2, wobei die Thermistorsensorstruktur (3) entlang des Wärmeableitungspfads (15) auf einer dem Halbleiterbauelement (7) zugewandten und auf einer dem Halbleiterbauelement (7) abgewandten Seite des Trägerkörpers (14) angeordnet ist.

7. Verfahren nach einem der vorherigen Ansprüche, wobei der Keramikkörper (4) Aluminiumoxid oder Aluminiumnitrid aufweist.

8. Verfahren nach einem der vorherigen Ansprüche, wobei der Keramikkörper (4) einen spezifischen elektrischen Widerstand von mehr als 50000 Ohm·cm aufweist.

9. Verfahren nach einem der vorherigen Ansprüche, wobei die integrierte Thermistorsensorstruktur (3) einen spezifischen elektrischen Widerstand von weniger als 5000 Ohm·cm aufweist.

10. Verfahren nach einem der Ansprüche 1 bis 9, wobei die integrierte Thermistorsensorstruktur (3) als NTC-Thermistor ausgebildet ist.

11. Verfahren nach einem der Ansprüche 1 bis 9, wobei die integrierte Thermistorsensorstruktur (3) als PTC-Thermistor ausgebildet ist.

12. Verfahren nach einem der vorherigen Ansprüche, wobei die Wärmesenke (1) als metallische Wärmesenke ausgebildet ist.

13. Verfahren nach einem der vorherigen Ansprüche, wobei der Trägerkörper (14) direkt auf der Wärmesenke (1) montiert wird.

14. Verfahren nach einem der vorherigen Ansprüche, wobei der Trägerkörper (14) eine Kontaktstruktur (6) aufweist, über die das Halbleiterbauelement (7) auf dem Trägerkörper (14) montiert wird.

15. Verfahren nach einem der vorherigen Ansprüche, wobei der Trägerkörper (14) eine Metallstruktur (8) zur Umverdrahtung und zum elektrischen Anschluss des Halbleiterbauelements (7) aufweist.

16. Verfahren nach einem der vorherigen Ansprüche, wobei der Trägerkörper (14) zwischen der Thermistorsensorstruktur (3) und dem Halbleiterbauelement (7) eine Isolatorschicht (5) aufweist.

17. Verfahren nach Anspruch 16, wobei die Isolatorschicht (5) reflektierend oder reflektierend und weiß ausgebildet ist.

18. Verfahren nach Anspruch 16 oder 17, wobei die Isolatorschicht (5) ein isolierendes Keramikmaterial ausgewählt aus Titanoxid, Aluminiumoxid und Siliziumoxid oder ein Kunststoffmaterial aufweist.

19. Verfahren nach einem der vorherigen Ansprüche, wobei der Trägerkörper (14) thermische Vias (11) aufweist, die durch den Keramikkörper (4) hindurchragen und in thermischem Kontakt mit der integrierten Thermistorsensorstruktur stehen.

20. Verfahren nach Anspruch 19, wobei die thermischen Vias (11) durch mit Metall gefüllte Öffnungen gebildet werden.

21. Verfahren nach Anspruch 19 oder 20, wobei zwischen den thermischen Vias (11) und der Thermistorsensorstruktur (3) Isolatorschichten angeordnet sind, um die von der Wärmesenke (1) aus gesehene Unterseite des Trägerkörpers (14) elektrisch von der Thermistorsensorstruktur (3) zu isolieren.

22. Verfahren nach einem der vorherigen Ansprüche, wobei der Trägerkörper (14) mittels eines Kontaktpads (2) mit der Wärmesenke (1) verbunden ist.

23. Verfahren nach einem der vorherigen Ansprüche, wobei auf der Wärmesenke (1) eine Mehrzahl von Trägerkörpern (14) mit jeweils einem darauf montierten Halbleiterbauelement (7) aufgebracht wird.

24. Verfahren nach einem der vorherigen Ansprüche, wobei auf der Wärmesenke (1) weiterhin ein diskretes Schutzbauelement (10) angeordnet wird.

25. Verfahren nach einem der vorherigen Ansprüche, wobei das Halbleiterbauelement (7) ein Leistungshalbleiterbauelement ausgewählt aus einer Licht emittierenden Diode, einem Graphikchip, einem Verstärkerchip und einem Transistor ist.

## Claims

1. Method for producing a semiconductor device comprising the following steps:
- providing a semiconductor component (7),
- providing a carrier body (14), on which the semiconductor component (7) is mounted and which comprises a ceramic body (4) and a thermistor sensor structure (3) integrated into the carrier body (14) and directly connected to the ceramic body (4), wherein the ceramic body (4) and the thermistor sensor structure (3) are produced in a common process and form a monolithic ceramic part, and
- providing a heat sink (1), on which the carrier body (14) is mounted.

2. Method according to Claim 1, wherein the thermistor sensor structure (3) is arranged in a heat dissipating path (15) between the semiconductor component (7) and the heat sink (1).

3. Method according to Claim 2, wherein the thermistor sensor structure (3) is arranged along the heat dissipating path (15) on a side of the carrier body (14) that faces or faces away from the semiconductor component (7).

4. Method according to Claim 3, wherein the thermistor sensor structure (3) is arranged along the heat dissipating path (15) on a side of the carrier body (14) that faces the semiconductor component (7), and the carrier body (14) furthermore comprises a metal film (12) on a side facing away from the semiconductor component (7).

5. Method according to Claim 4, wherein the metal film (12) is a copper film.

6. Method according to Claim 2, wherein the thermistor sensor structure (3) is arranged along the heat dissipating path (15) on a side of the carrier body (14) that faces the semiconductor component (7) and on a side of said carrier body that faces away from the semiconductor component (7).

7. Method according to any of the preceding claims, wherein the ceramic body (4) comprises aluminum oxide or aluminum nitride.

8. Method according to any of the preceding claims, wherein the ceramic body (4) has an electrical resistivity of more than 50,000 ohms·cm.

9. Method according to any of the preceding claims, wherein the integrated thermistor sensor structure (3) has an electrical resistivity of less than 5000 ohms·cm.

10. Method according to any of Claims 1 to 9, wherein the integrated thermistor sensor structure (3) is embodied as an NTC thermistor.

11. Method according to any of Claims 1 to 9, wherein the integrated thermistor sensor structure (3) is embodied as a PTC thermistor.

12. Method according to any of the preceding claims, wherein the heat sink (1) is embodied as a metallic heat sink.

13. Method according to any of the preceding claims, wherein the carrier body (14) is mounted directly on the heat sink (1).

14. Method according to any of the preceding claims, wherein the carrier body (14) comprises a contact structure (6), by way of which the semiconductor component (7) is mounted on the carrier body (14).

15. Method according to any of the preceding claims, wherein the carrier body (14) comprises a metal structure (8) for redistribution wiring and for electrical connection of the semiconductor component (7).

16. Method according to any of the preceding claims, wherein the carrier body (14) comprises an insulator layer (5) between the thermistor sensor structure (3) and the semiconductor component (7).

17. Method according to Claim 16, wherein the insulator layer (5) is embodied such that it is reflective or reflective and white.

18. Method according to Claim 16 or 17, wherein the insulator layer (5) comprises an insulating ceramic material selected from titanium oxide, aluminum oxide and silicon oxide or a plastics material.

19. Method according to any of the preceding claims, wherein the carrier body (14) comprises thermal vias (11) which project through the ceramic body (4) and are in thermal contact with the integrated thermistor sensor structure.

20. Method according to Claim 19, wherein the thermal vias (11) are formed by openings filled with metal.

21. Method according to Claim 19 or 20, wherein insulator layers are arranged between the thermal vias (11) and the thermistor sensor structure (3) in order that the underside of the carrier body (14) as viewed from the heat sink (1) is electrically insulated from the thermistor sensor structure (3).

22. Method according to any of the preceding claims, wherein the carrier body (14) is connected to the heat sink (1) by means of a contact pad (2).

23. Method according to any of the preceding claims, wherein a plurality of carrier bodies (14) each with a semiconductor component (7) mounted thereon are applied on the heat sink (1).

24. Method according to any of the preceding claims, wherein a discrete protective component (10) is furthermore arranged on the heat skin (1).

25. Method according to any of the preceding claims, wherein the semiconductor component (7) is a power semiconductor component selected from a light-emitting diode, a graphics chip, an amplifier chip and a transistor.

## Revendications

1. Procédé de fabrication d'un dispositif semi-conducteur comprenant les étapes suivantes:
- fournir un dispositif semi-conducteur (7),
- fournir un corps de support (14) sur lequel est monté l'élément semi-conducteur (7) et qui comporte un corps céramique (4) et une structure de capteur à thermistance (3) intégrée dans le corps de support (14) en liaison directe avec le corps céramique (4), dans lequel le corps céramique (4) et la structure de capteur à thermistance (3) sont fabriqués dans un processus commun et forment une pièce céramique monolithique, et
- fournir un dissipateur thermique (1) sur lequel est monté le corps de support (14).

2. Procédé selon la revendication 1, dans lequel la structure de capteur à thermistance (3) est disposée sur un trajet de dissipation thermique (15) entre l'élément semi-conducteur (7) et le dissipateur thermique (1).

3. Procédé selon la revendication 2, dans lequel la structure de capteur à thermistance (3) est disposée le long du trajet de dissipation thermique (15) sur un côté du corps de support (14) qui est tourné vers ou à l'opposé du composant semi-conducteur (7).

4. Procédé selon la revendication 3, dans lequel la structure de capteur à thermistance (3) est disposée le long du trajet de dissipation thermique (15) sur un côté du corps de support (14) qui est tourné vers le composant semi-conducteur (7) et le corps de support (14) comprend en outre une feuille métallique (12) sur un côté qui est tourné à l'opposé du composant semi-conducteur (7).

5. Procédé selon la revendication 4, dans lequel la feuille métallique (12) est une feuille de cuivre.

6. Procédé selon la revendication 2, dans lequel la structure de capteur à thermistance (3) est disposée le long du trajet de dissipation thermique (15) sur un côté du corps de support (14) qui est tourné vers le composant semi-conducteur (7) et sur un côté du corps de support (4) qui est tourné à l'opposé du composant semi-conducteur (7).

7. Procédé selon l'une des revendications précédentes, dans lequel le corps céramique (4) comprend de l'oxyde d'aluminium ou du nitrure d'aluminium.

8. Procédé selon l'une des revendications précédentes, dans lequel le corps céramique (4) présente une résistance électrique spécifique de plus de 50000 ohm·cm.

9. Procédé selon l'une des revendications précédentes, dans lequel la structure de capteur à thermistance (3) intégrée présente une résistance électrique spécifique inférieure à 5000 ohm·cm.

10. Procédé selon l'une des revendications 1 à 9, dans lequel la structure de capteur à thermistance (3) intégrée est réalisée sous la forme d'une thermistance NTC.

11. Procédé selon l'une des revendications 1 à 9, dans lequel la structure de capteur à thermistance (3) intégrée est réalisée sous la forme d'une thermistance PTC.

12. Procédé selon l'une des revendications précédentes, dans lequel le dissipateur thermique (1) est réalisé sous la forme d'un dissipateur thermique métallique.

13. Procédé selon l'une des revendications précédentes, dans lequel le corps de support (14) est monté directement sur le dissipateur thermique (1).

14. Procédé selon l'une des revendications précédentes, dans lequel le corps de support (14) présente une structure de contact (6) par le biais de laquelle le composant semi-conducteur (7) est monté sur le corps de support (14) .

15. Procédé selon l'une des revendications précédentes, dans lequel le corps de support (14) présente une structure métallique (8) pour le recâblage et la connexion électrique du composant semi-conducteur (7).

16. Procédé selon l'une des revendications précédentes, dans lequel le corps de support (14) comporte une couche isolante (5) entre la structure de capteur à thermistance (3) et le composant semi-conducteur (7).

17. Procédé selon la revendication 16, dans lequel la couche isolante (5) est réfléchissante ou réfléchissante et blanche.

18. Procédé selon la revendication 16 ou 17, dans lequel la couche isolante (5) comprend un matériau céramique isolant choisi parmi l'oxyde de titane, l'oxyde d'aluminium et l'oxyde de silicium ou un matériau plastique.

19. Procédé selon l'une des revendications précédentes, dans lequel le corps de support (14) présente des traversées thermiques (11) qui traversent le corps céramique (4) et sont en contact thermique avec la structure de capteur à thermistance intégrée.

20. Procédé selon la revendication 19, dans lequel les traversées thermiques (11) sont formées par des ouvertures remplies de métal.

21. Procédé selon la revendication 19 ou 20, dans lequel des couches isolantes sont disposées entre les traversées thermiques (11) et la structure de capteur à thermistance (3) afin d'isoler électriquement la face inférieure du corps de support (14), vue depuis le dissipateur thermique (1), de la structure de capteur à thermistance (3).

22. Procédé selon l'une des revendications précédentes, dans lequel le corps de support (14) est relié au dissipateur thermique (1) au moyen d'un plot de contact (2).

23. Procédé selon l'une des revendications précédentes, dans lequel une pluralité de corps de support (14), sur chacun desquels est monté un composant semi-conducteur (7), est montée sur le dissipateur thermique (1).

24. Procédé selon l'une des revendications précédentes, dans lequel un composant de protection discret (10) est en outre disposé sur le dissipateur thermique (1).

25. Procédé selon l'une des revendications précédentes, dans lequel le composant semi-conducteur (7) est un composant semi-conducteur de puissance choisi parmi une diode électroluminescente, une puce graphique, une puce amplificatrice et un transistor.
